(19) Europäisches Patentamt
European Patent Office
Office européen des brevets

(11) **EP 1 596 214 B1**

(12) **EUROPÄISCHE PATENTSCHRIFT**

(45) Veröffentlichungstag und Bekanntmachung des Hinweises auf die Patenterteilung:
**18.01.2012 Patentblatt 2012/03**

(51) Int Cl.:
*G01R 33/3815* (2006.01)   *F25B 9/14* (2006.01)

(21) Anmeldenummer: **05009743.5**

(22) Anmeldetag: **04.05.2005**

(54) **Magnetsystem mit einem Pulsrohrkühler**

Magnet system with a pulse tube refrigerator

Système magnétique avec un réfrigérateur à tube pulsé

(84) Benannte Vertragsstaaten:
**CH DE FR GB LI**

(30) Priorität: **11.05.2004 DE 102004023072**

(43) Veröffentlichungstag der Anmeldung:
**16.11.2005 Patentblatt 2005/46**

(73) Patentinhaber: **Bruker BioSpin AG**
**8117 Fällanden (CH)**

(72) Erfinder:
• **Bovier, Pierre-Alain, Dr.**
**8051 Zürich (CH)**
• **Vonlanthen, Patrik, Dr.**
**8603 Schwerzenbach (CH)**
• **Kraus, Andreas, Dr.**
**8616 Riedikon (CH)**

(74) Vertreter: **Kohler Schmid Möbus**
**Patentanwälte**
**Ruppmannstraße 27**
**70565 Stuttgart (DE)**

(56) Entgegenhaltungen:
**EP-A- 0 905 434    GB-A- 2 292 449**
**US-A- 5 701 744**

• **WANG C: "Helium liquefaction with a 4 K pulse tube cryocooler" CRYOGENICS, BUTTERWORTH SCIENTIFIC, GUILDFORD, GB, Bd. 41, Nr. 7, Juli 2001 (2001-07), Seiten 491-496, XP004307313 ISSN: 0011-2275**
• **WANG C ET AL: "A single-stage pulse tube cryocooler for horizontally cooling HTS MRI probe" AIP CONFERENCE PROCEEDINGS AIP USA, ADVANCES IN CRYOGENIC ENGINEERING. CRYOGENIC ENGINEERING CONFERENCE, 22-26.09.2003, ANCHORAGE, AK,USA, Nr. 710, 23. Juni 2004 (2004-06-23), Seiten 1805-1811, XP002341035 ISSN: 0094-243X**

**Beschreibung**

Die Erfindung betrifft ein Magnetsystem mit einer Magnetanordnung, einem Arbeitsvolumen und einem Pulsrohrkühler mit magnetischem Regeneratormaterial.

Die Verwendung von Pulsrohrkühlern zur Kühlung von Elementen einer Magnetanordnung ist beispielsweise aus der EP 0 905 434 bekannt. Dort wird der Pulsrohrkühler dazu verwendet, das Heliumbad auf Temperaturen unter 4.2 K zu bringen. Die sich darin befindenden Magnetspulen können ein höheres Feld als bei 4.2 K erzeugen, da bei tieferer Temperatur höhere Ströme durch den Supraleiter fließen können.

Aus der US 6,029,458 ist eine Magnetanordnung mit einem Kolbenrefrigerator bekannt, der einen Schieber aus Materialien mit magnetischem Phasenübergang aufweist. Zur Abschirmung der durch die Bewegung des Schiebers auftretenden Störfelder wird eine den Refrigerator umgebende supraleitende Hülse vorgeschlagen, die zwischen dem kalten Ende des Refrigerators und dem Untersuchungsvolumen angeordnet ist. Die supraleitende Hülse umgibt dabei 90˚ bis 270˚ des kalten Endes des Refrigerators. Durch das magnetische Störfeld des Regeneratormaterials wird in der Hülse ein dem Störfeld entgegen gesetztes magnetisches Feld induziert, das den magnetischen Fluss durch die Hülse konstant halten und das Störfeld somit kompensieren soll. Es hat sich jedoch herausgestellt, dass derartige Anordnungen eine hohe Quenchgefahr bergen, und somit keine zuverlässige und stabile Abschirmung ermöglichen. Zudem können Felder parallel zur Hülse nicht kompensiert werden, weil sich Abschirmströme aufgrund des unvollständigen Umfangs von 90˚ bis 270˚ praktisch nicht aufbauen können.

US 5 701 744 A offenbart ein Magnetsystem mit einem Kryokühler aus seltenen Erden, welche durch ihre Bewegung ein unerwünschtes magnetisches Wechselfeld im Messvolumen erzeugen. Dies wird durch induzierte Ströme in einer supraleitenden Abschirmung unterdrückt. Die Quenchgefahr wird jedoch nicht gebannt.

Des Weiteren ist aus der EP 0 905 524 ein Magnetsystem mit einer supraleitenden Magnetanordnung und einem Pulsrohrkühler bekannt. In diesem Magnetsystem ist der Pulsrohrkühler in einem Aufhängerohr des Systems angeordnet. Er kann eine verdampfende kryogene Flüssigkeit wieder verflüssigen.

Pulsrohrkühler weisen, verglichen mit anderen Kühlern, viel weniger Vibrationen auf, was bei störempfindlichen Magnetsystemen ein großer Vorteil ist. Um die Kühlung von Tieftemperatursupraleitern zu ermöglichen, sind Temperaturen von und unter 4.2 K von Interesse. Besonders hohe Kühlleistungen haben in diesem Temperaturbereich Pulsrohrkühler mit magnetischen Regeneratormaterialien. Insbesondere seltene Erden im Regeneratormaterial eines Pulsrohrkühlers ermöglichen eine gute Kühlleistung, sogar bei Temperaturen bis 4.2 K. Diese gute Kühlleistung ist auf die große Wärmekapazität der seltenen Erden in der Nähe ihres magnetischen Phasenübergangs zurückzuführen. Aufgrund dieses Phasenübergangs werden die seltenen Erden vom Streufeld der Magnetanordnung magnetisiert. Innerhalb eines Kühlzyklus verändern sich mit der Temperatur auch die magnetischen Eigenschaften des Regeneratormaterials. Seine Magnetisierung im Streufeld der Magnetanordnung verändert sich also periodisch. Diese Schwankung der Magnetisierung bewirkt eine zeitlich veränderliche elektromagnetische Störung im Arbeitsvolumen der Magnetanordnung. Diese Zeitabhängigkeit der Magnetisierung wurde in der Patentschrift EP 0 905 434 übersehen. Vielmehr ging man dort davon aus, dass die Magnetisierung des Regeneratormaterials eine statische Homogenitätsstörung im Arbeitsvolumen erzeugt, was unproblematisch wäre.

Aufgabe der vorliegenden Erfindung ist es, ein Magnetsystem vorzuschlagen, das mit einem Pulsrohrkühler mit magnetischem Regeneratormaterial ausgestattet ist und trotzdem ein möglichst stabiles, zeitlich konstantes Magnetfeld im Arbeitsvolumen realisiert.

Diese Aufgabe wird erfindungsgemäß dadurch gelöst, dass eine Abschirmung aus magnetischem Material vorgesehen ist, welche das Streufeld der Magnetanordnung am Ort des magnetischen Regeneratormaterials reduziert und sich dadurch auszeichnet, dass

$$\frac{1}{3}\left|\tilde{m}_{\text{Reg}}R\right| + \left|m_{\text{Mag}}\Delta x\right| < \frac{1}{6}\left|m_{\text{Reg}}R\right|$$

wobei $m_{\text{Mag}}$ für das Dipolmoment des magnetischen Materials der Abschirmung, $\Delta x$ für die Vibrationsamplitude des magnetischen Materials der Abschirmung, $m_{\text{Reg}}$ für die Amplitude der Dipolschwankungen des magnetischen Regeneratormaterials in einem Zyklus ohne magnetische Abschirmung, $\bar{m}_{\text{Reg}}$ für die Amplitude der Dipolschwankungen des magnetischen Regeneratormaterials in einem Zyklus mit magnetischer Abschirmung und R für den mittleren Abstand des magnetischen Regeneratormaterials zum Arbeitsvolumen steht.

Durch die erfindungsgemäße Abschirmung aus magnetischem Material kann das Streufeld der Magnetanordnung am Ort des magnetischen Regeneratormaterials abgeschirmt werden. Somit können die Dipolschwankungen des magnetischen Regeneratormaterials reduziert und die daraus resultierenden elektromagnetischen Störungen im Arbeitsvolumen der Magnetanordnung effizient unterdrückt werden. Besonders geeignet zur Abschirmung des magnetischen Regeneratormaterials ist weichmagnetisches Material, welches Feldlinien anzieht und so das Magnetfeld in seinem Inneren abschirmt.

Durch das Streufeld der Magnetanordnung wird das Material des Hohlzylinders magnetisiert und bildet einen magnetischen Dipol. Obwohl ein Pulsrohrkühler zu den vibrationsärmsten Kühlern überhaupt gehört, sind kleinere Vibrationen vorhanden, die auf die Abschirmung aus magnetischem Material übertragen werden können. Die erfindungsgemäße Abschirmung aus magnetischem Material kann als vibrierender magnetischer Dipol angesehen werden, welcher im Arbeitsvolumen der Magnetanordnung eine periodische elektromagnetische Störung erzeugt, die unter Umständen größer sein kann als die ursprüngliche Störung des magnetischen Regeneratormaterials. Um dieses Problem zu vermeiden, muss der Betrag der Feldstörung vom magnetischem Regeneratormaterial und von der magnetischen Abschirmung im Arbeitsvolumen der Magnetanordnung abgeschätzt und die Parameter der Abschirmung entsprechend ausgelegt werden. Wenn die oben aufgeführte Ungleichung

$$\frac{1}{3}\left|\tilde{m}_{\text{Reg}}R\right| + \left|m_{\text{Mag}}\Delta x\right| < \frac{1}{6}\left|m_{\text{Reg}}R\right|$$

erfüllt ist, ist die Störung, die aufgrund von der vibrierenden Abschirmung im Arbeitsvolumen erzeugt wird, mindestens einen Faktor zwei kleiner als diejenige, die das magnetische Regeneratormaterial ohne magnetische Abschirmung erzeugen würde. Das erfindungsgemäße Magnetsystem weist daher gegenüber bekannten Magnetsystemen eine erhebliche Reduzierung der im Arbeitsvolumen auftretenden Störungen auf, die aus dem Betrieb eines Pulsrohrkühlers mit magnetischem Regeneratormaterial resultieren.

Ein Einsatzgebiet von Pulsrohrkühlern in dem erfindungsgemäßen Magnetsystem umfasst beispielsweise die Kühlung einer supraleitenden Magnetanordnung oder Teile eines Kryostaten, in welcher sich die supraleitende Magnetanordnung befindet. Die tiefen Temperaturen sind in einem solchen Magnetsystem aufgrund der supraleitenden Eigenschaften der Drähte nötig. Derartige Magnetsysteme werden beispielsweise zur Erzeugung extrem hoher, homogener Magnetfelder verwendet.

Bei einem weiteren Einsatzgebiet des Pulsrohrkühlers wird die Kühlung von Messvorrichtungen im Arbeitsvolumen der Magnetanordnung angestrebt mit dem Vorteil der Reduktion des thermischen Rauschens im Signal. Insbesondere in der Magnetresonanzspektroskopie reduziert die Kühlung der Messvorrichtung den Rauschpegel im Signal dermaßen, dass erheblich kürzere Messzeiten möglich werden.

In einer besonders bevorzugten Ausführungsform des Magnetsystems weist das magnetische Material der Abschirmung eine maximale Permeabilität $\mu_{\text{max}}$ von mindestens 10000 auf. Die maximale Permeabilität ist der größte Wert der relativen Permeabilität, welche eine Funktion des Feldes ist. Da die relative Permeabilität ein Maß für die Abschirmwirkung ist, kann eine magnetische Abschirmung aus einem Material mit hoher maximaler Permeabilität das Streufeld der Magnetanordnung am Ort des magnetischen Regeneratormaterials am besten abschirmen. Ein weiterer Vorteil ergibt sich daraus, dass die magnetische Abschirmung, solange sie nicht in der magnetischen Sättigung ist, Reststörungen, die im magnetischen Regeneratormaterial eventuell noch entstehen, durch Variationen ihrer Magnetisierung entgegenwirken und so die Störamplitude im Arbeitsvolumen noch weiter reduzieren kann.

Besonders vorteilhaft ist es, wenn die Sättigungsinduktion des magnetischen Materials mindestens 1 Tesla, vorzugsweise 2 Tesla beträgt. So kann auch einem relativ starken Streufeld der Magnetanordnung am Ort des magnetischen Regeneratormaterials mit wenig Abschirmmaterial ein Gegenfeld aufgebaut werden. Eine hohe Sättigungsinduktion bewirkt auch, dass das magnetische Material nicht leicht in die magnetische Sättigung getrieben wird. Das magnetische Material schirmt so einerseits das Streufeld der Magnetanordnung am Ort des magnetischen Regeneratormaterials immer noch ab und kann andererseits den eventuell noch im magnetischen Regeneratormaterial entstehenden Störungen durch Variationen seiner Magnetisierung im Arbeitsvolumen entgegenwirken.

In einer bevorzugten Ausführungsform umfasst die magnetische Abschirmung mindestens einen Hohlzylinder, der das abzuschirmende magnetische Regeneratormaterial umschließt. Da der Regenerator meistens die Geometrie eines Zylinders aufweist, ist ein Hohlzylinder die einfachst mögliche Ausführungsform für die magnetische Abschirmung. Typischerweise werden Abschirmmaterialien in Folien hergestellt. Das Aufwickeln von Folie auf einem Zylinderträger führt auf einfache Weise zur gewünschten Geometrie.

In einer besonders bevorzugten Ausführungsform besteht der innere Teil des Hohlzylinders aus Material mit hoher Permeabilität $\mu_{\text{max}} > 10000$, während der äußere Teil aus Material mit hoher Sättigungsinduktion >1 Tesla besteht. Durch die hohe Sättigungsinduktion des äußeren Materials wird eine starke Reduzierung des Streufelds der Magnetanordnung erreicht, wodurch sich der innere Teil des Hohlzylinders mit der hohen Permeabilität bereits in einem stark reduzierten Feld befindet, welches dann optimal abgeschirmt werden kann. Insbesondere kann ein starkes Streufeld der Magnetanordnung am Ort des Regenerators gut abgeschirmt und somit die Entstehung einer elektromagnetischen Störung im magnetischem Regeneratormaterial unterdrückt werden.

Vorteilhafterweise soll der Außendurchmesser des Hohlzylinders kleiner als das 1,5-fache des Außendurchmessers des abzuschirmenden magnetischen Regeneratormaterials sein. Je kleiner der Außendurchmesser des Hohlzylinders ist, desto kleiner ist auch das Dipolmoment des magnetischen Materials, aus dem der Hohlzylinder besteht, so dass die geforderte Bedingung, nämlich dass

$$\frac{1}{3}\left|\tilde{m}_{\text{Reg}}R\right| + \left|m_{\text{Mag}}\Delta x\right| < \frac{1}{6}\left|m_{\text{Reg}}R\right|$$

erfüllt ist. Ein kleiner Außendurchmesser des Hohlzylinders bewirkt auch, dass das weichmagnetische Material nicht magnetisch gesättigt wird. Deshalb wird einerseits das Streufeld der Magnetanordnung am Ort des magnetischen Regeneratormaterials immer noch abgeschirmt und andererseits können die eventuell noch im magnetischen Regeneratormaterial entstehenden Störungen durch Variationen der Magnetisierung des Hohlzylinders im Arbeitsvolumen reduziert werden.

In einer bevorzugten Ausführungsform des erfindungsgemäßen Magnetsystems überragt mindestens ein axiales Ende des Hohlzylinders das abzuschirmende magnetische Regeneratormaterial um mindestens ein Drittel des Innendurchmessers des Hohlzylinders. Diese über die eigentliche Abmessung des abzuschirmenden magnetischen Regeneratormaterials hinausgehende Verlängerung des Hohlzylinders gewährleistet, dass das Streufeld der Magnetanordnung am Ort des magnetischen Regeneratormaterials wirklich durch die Abschirmung reduziert wird. An den axialen Enden des Hohlzylinders müssen nämlich konzentrierte Feldlinien das magnetische Material wieder verlassen, was vor allem bei Feldern parallel zur Achse des Zylinders zu lokalen Feldüberhöhungen führt.

In einer besonders bevorzugten Ausführungsform überragt mindestens ein axiales Ende des Hohlzylinders das abzuschirmende magnetische Regeneratormaterial um höchstens das Zweifache des Innendurchmessers des Hohlzylinders. Da mit wachsender Ausdehnung des Hohlzylinders die Sättigung des magnetischen Materials schneller erreicht ist, ist es wünschenswert, den Hohlzylinder so kurz wie möglich auszuführen, wobei jedoch bei der Wahl der Abmessung des Hohlzylinders auch die zuvor beschriebenen Randeffekte beachtet werden müssen, um eine befriedigende Abschirmwirkung zu erreichen.

In einer bevorzugten Ausführungsform des erfindungsgemäßen Magnetsystems umfasst das abzuschirmende magnetische Regeneratormaterial lediglich Bereiche des Regeneratormaterials, an denen Magnetisierungsschwankungen stattfinden, die mehr als 10% der im Regeneratorbetrieb auftretenden maximalen Magnetisierungsschwankung innerhalb des gesamten Regeneratormaterials betragen. Somit wird das Volumen des magnetischen Materials der Abschirmung auf ein tragbares Minimum reduziert, so dass einerseits Materialkosten eingespart werden können und andererseits die infolge der Vibrationen der Abschirmung auftretenden Störungen minimiert werden.

Des Weiteren ist es vorteilhaft, wenn sich im Betrieb zumindest ein Teil des magnetischen Materials nicht in der magnetischen Sättigung befindet, da ein Material in der magnetischen Sättigung einen Teil des Streufeldes der Magnetanordnung nicht abschirmen kann. Auch Störungen, die eventuell im Regeneratormaterial noch entstehen, können durch ein Material in der magnetischen Sättigung im Arbeitsvolumen nicht kompensiert werden.

Besonders vorteilhaft ist es, wenn die Abschirmung aus magnetischem Material temperaturstabilisert, insbesondere wärmeleitend mit einem Strahlungsschild, einer Kältestufe des Pulsrohrkühlers oder einem Behälter mit kryogener Flüssigkeit verbunden ist. Dies ist vor allem interessant, wenn sich die Abschirmung nahe am magnetischem Regeneratormaterial befindet, da sich die im magnetischem Regeneratormaterial stattfindenden Temperaturschwankungen auch auf das magnetische Material der Abschirmung übertragen könnten. Mit ihren temperaturabhängigen magnetischen Eigenschaften wäre sonst die magnetische Abschirmung ein zeitabhängiger magnetischer Dipol und würde im Arbeitsvolumen unerwünschte elektromagnetische Störungen erzeugen.

Um die Temperaturschwankungen in der magnetischen Abschirmung zu unterdrücken, kann die Abschirmung aus magnetischem Material vom magnetischem Regeneratormaterial thermisch isoliert werden. Thermische Isolation beinhaltet die Reduzierung von Wärmeleitung, Wärmestrahlung und/oder Konvektion.

In einer weiteren Ausführungsform des erfindungsgemäßen Magnetsystems ist zusätzlich zur magnetischen Abschirmung auch eine Abschirmung aus elektrisch gut leitendem Material um das magnetische Regeneratormaterial vorgesehen. Hierdurch können die trotz der magnetischen Abschirmung noch verbleibenden Störungen kompensiert werden. Auf diese Weise können beispielsweise Vibrationen der magnetischen Abschirmung oder noch vorhandene Dipolschwankungen des magnetischen Regeneratormaterials durch den Aufbau eines Gegenfelds durch Abschirmströme im elektrisch gut leitenden Material kompensiert werden.

In einer besonders bevorzugten Ausführungsform der Erfindung weist die Abschirmung aus elektrisch gut leitendem Material Teile mit einer Zylindersymmetrie auf, und die Magnetfeldänderungen des magnetischen Regeneratormaterials und/oder der magnetischen Abschirmung am Ort der elektrisch gut leitenden Abschirmung zeigen überwiegend in Richtung der entsprechenden Zylinderachse. Ein Zylinder aus elektrisch gut leitendem Material kann nämlich Feldschwankungen parallel zu seiner Achse am besten gegen außen kompensieren, da die Abschirmströme auf dem Zylinder vor allem in Umfangsrichtung unbehindert fließen können.

Bei dem elektrisch gut leitenden Material handelt es sich vorteilhafterweise um einen Tieftemperatursupraleiter. Durch den verschwindenden Widerstand eines Supraleiters werden die Induktionsströme ungehindert aufgebaut. Somit können auftretende Störungen optimal kompensiert werden. Der Einsatz eines Tieftemperatursupraleiters bedingt aber, dass dieser einer hinreichend tiefen Temperatur ausgesetzt ist. Diese tiefe Temperatur kann beispielsweise durch thermische Kontaktierung des Supraleiters mit einer Kältestufe des Pulsrohrkühlers oder mit einem kalten Behälter im Kryostaten erreicht werden.

Da die zur Erzeugung von Supraleitung mit Hilfe eines Tieftemperatursupraleiters benötigten tiefen Temperaturen nicht bei allen Verfahren gewährleistet werden können, ist auch eine Ausführungsform des erfindungsgemäßen Magnetsystems denkbar, bei dem das elektrisch gut leitende Material ein Hochtemperatursupraleiter ist. Die dafür notwendige Temperatur kann beispielsweise durch thermische Kontaktierung des Supraleiters mit der ersten Stufe eines zweistufigen Pulsrohrkühlers oder mit einem kalten Behälter im Kryostaten erreicht werden.

In einer bevorzugten Ausführungsform der Erfindung besteht das elektrisch gut leitende Material aus Massivmaterial, beispielsweise aus einem zylinderförmigen Block. In dieser Ausführungsform können die Abschirmströme in allen Richtungen fließen, so dass sie elektromagnetische Störungen optimal kompensieren können.

In einer besonders bevorzugten Ausführungsform bildet das elektrisch gut leitende Material eine Solenoidspule. Da Supraleiter in Form von Bändern oder von Drähten erhältlich sind, bietet es sich an, damit eine Solenoidspule zu wickeln.

Darüber hinaus ist es vorteilhaft, wenn die supraleitende Magnetanordnung mit Spulen zur Streufeldunterdrückung ausgestattet ist. Durch eine derartige aktive Abschirmung wird das Magnetfeld am Ort des magnetischen Regeneratormaterials und somit die dadurch auftretenden Störungen reduziert, so dass die zuvor beschriebenen Abschirmvorrichtungen aus magnetischem Materials lediglich ein reduziertes Störfeld kompensieren müssen.

Das Magnetfeld am Ort des magnetischen Regeneratormaterials überschreitet dabei vorzugsweise 10 mT nicht. Ein solches Feld kann mit einer vernünftigen Menge an weichmagnetischem Material abgeschirmt werden.

Des Weiteren ist es von Vorteil, wenn die supraleitende Magnetanordnung Spulen aufweist, welche die elektromagnetischen Störungen des magnetischen Regeneratormaterials unterdrücken. Mit derartigen Zusatzspulen können die eventuell noch vorhandenen Störungen des magnetischen Regeneratormaterials im Arbeitsvolumen kompensiert werden.

Durch die sich periodisch ändernde Druckwelle im Regeneratormaterial entstehen Vibrationen, die sich auf die magnetische Abschirmung übertragen können. Auch der Kompressor des Pulsrohrkühlers oder Bodenvibrationen können die magnetische Abschirmung zum Schwingen bringen. Es ist daher vorteilhaft, wenn die supraleitende Magnetanordnung Spulen aufweist, welche die elektromagnetischen Störungen der vibrierenden magnetischen Abschirmung unterdrücken.

In einer Ausführungsform des erfindungsgemäßen Magnetsystems enthält der Kryostat der supraleitenden Magnetanordnung einen Strahlungsschild, welchen der Pulsrohrkühler auf seine Betriebstemperatur bringt. Durch die Kühlung des Strahlungsschildes kann der Energieeintrag der warmen Umgebung auf die supraleitende Magnetanordnung reduziert werden.

In einer weiteren Ausführungsform des erfindungsgemäßen Magnetsystems enthält der Kryostat der supraleitenden Magnetanordnung einen Behälter mit flüssigem Stickstoff, welchen der Pulsrohrkühler nach dem Verdampfen mindestens teilweise wieder verflüssigt, was den Verbrauch von flüssigem Stickstoff reduziert oder eliminiert.

Vor allem bei einer Magnetanordnung mit Supraleitern kann flüssiges Helium zu deren Kühlung verwendet werden. In einer bevorzugten Ausführungsform des erfindungsgemäßen Magnetsystems wird das verdampfende flüssige Helium vom Pulsrohrkühler mindestens teilweise wieder verflüssigt. Somit kann der Heliumverbrauch reduziert oder eliminiert werden.

In einer anderen Ausführungsform der Erfindung wird die Magnetanordnung ohne kryogene Flüssigkeit vom Pulsrohrkühler auf ihre Betriebstemperatur gebracht und/oder gehalten. Somit wird das zeit- und kostenaufwändige Hantieren mit kryogenen Flüssigkeiten teilweise oder vollständig vermieden.

Die Vorteile des erfindungsgemäßen Magnetsystems kommen besonders gut zur Geltung, wenn die supraleitende Magnetanordnung Teil einer Apparatur zur Kernspinresonanz, insbesondere Magnetic Resonance Imaging (MRI) oder Magnetresonanzspektroskopie (NMR) ist, da bei derartigen Apparaturen ein besonders stabiles Magnetfeld benötigt wird.

Die Erfindung beinhaltet darüber hinaus ein Verfahren zum Betrieb eines Magnetsystems nach einem der Ansprüche 17 bis 20, wobei das supraleitende Material der Abschirmung während des Ladens der Magnetanordnung induktiv geladen wird. Durch dieses induktive Laden des supraleitenden Materials während des Ladens der Magnetanordnung wird das Streufeld der Magnetanordnung am Ort des magnetischen Regeneratormaterials kompensiert bzw. reduziert, so dass eine unerwünschte Magnetisierung des magnetischen Regeneratormaterials vermieden bzw. eingeschränkt wird.

Weitere Vorteile der Erfindung ergeben sich aus der Beschreibung und der Zeichnung. Ebenso können die vorstehend genannten und die weiter aufgeführten Merkmale je für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Es zeigen:

Fig. 1    ein erfindungsgemäßes Magnetsystem mit Pulsrohrkühler und magnetischer Abschirmung in Form eines Zylinders;

Fig. 2    typische BH-Kurven eines weichmagnetischen Materials mit hoher maximaler Permeabilität und eines weichmagnetischen Materials mit hoher maximaler Sättigungsinduktion;

Fig. 3b    eine Darstellung von Flusslinien in der Nähe einer zylindrischen Abschirmung m aus weichmagnetischem Material;

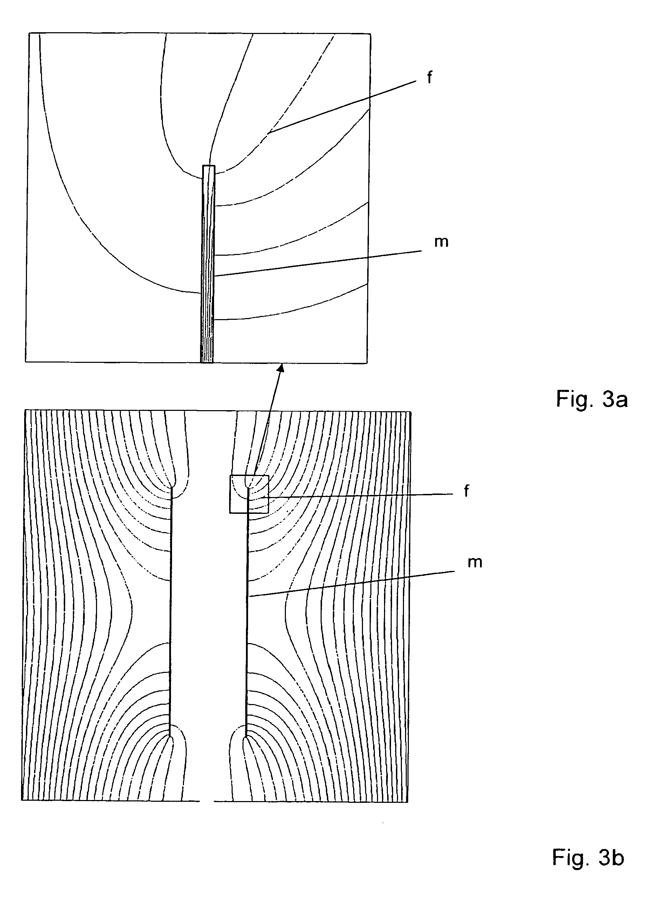

Fig. 3a    einen vergrößerten Ausschnitt aus Fig. 3b; und

Tab. 1    zwei Abschirmvarianten, die sich in ihren geometrischer Größen unterscheiden.

Um die durch die Schwankungen der Magnetisierung des magnetischen Regeneratormaterials **r** im Arbeitsvolumen **V** entstehenden elektromagnetischen Störungen zu unterdrücken, kann das Magnetfeld am Ort des magnetischen Regeneratormaterials r abgeschirmt werden. Besonders geeignet dazu ist weichmagnetisches Material, welches Feldlinien anzieht und so das Magnetfeld in seinem Inneren abschirmt.

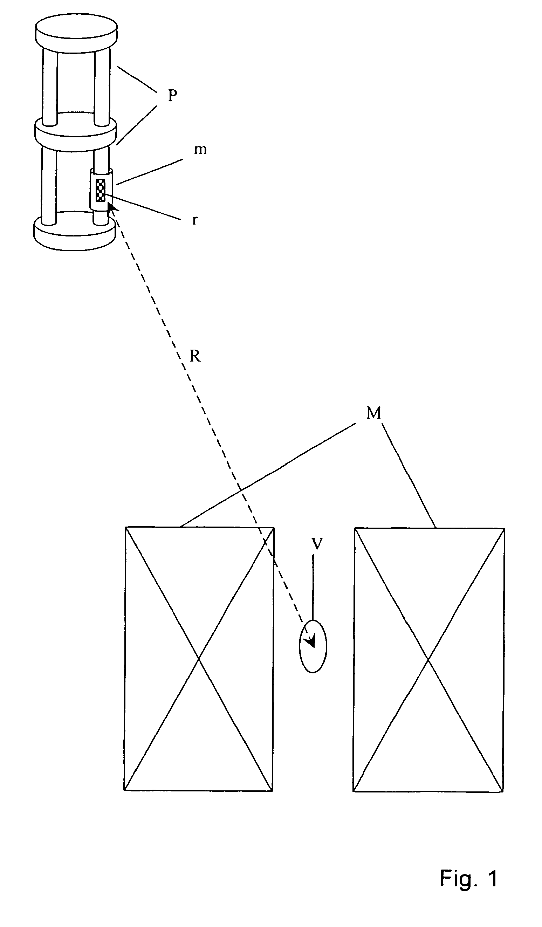

**Fig. 1** zeigt ein erfindungsgemäßes Magnetsystem **M,** in dem sich ein Arbeitsvolumen V befindet, mit einem entfernt vom Magnetsystem M angeordneten zweistufigen Pulsrohrkühler **P** und einer magnetischer Abschirmung **m.** Die magnetische Abschirmung m umschließt das magnetische Regeneratormaterial r der zweiten Stufe des Pulsrohrkühlers P und ist hier in einer besonders einfachen Ausführungsform, nämlich in Form eines Hohlzylinders, gezeigt. Diese magnetische Abschirmung m kann beispielsweise aus weichmagnetischem Material bestehen. Da weichmagnetisches Material oft in Folienform hergestellt wird, kann eine zylindrische Form durch Aufwickeln einer solchen Folie auf einen Zylinderträger einfach erhalten werden. Durch die Wahl der Lagenzahl kann die gewünschte Wandstärke der magnetischen Abschirmung m erreicht werden. Da die BH-Kurve eines weichmagnetischen Materials temperaturabhängig ist, müssen Temperaturschwankungen der magnetischen Abschirmung vermieden werden. Zum einen kann eine thermische Isolationsschicht zwischen weichmagnetischem Material und dem magnetischem Regeneratormaterial r vorgesehen werden, zum anderen kann eine thermische Kontaktierung des weichmagnetischen Materials mit vorhandenen temperaturstabilen Teilen der Anordnung zu diesem Ziel führen. Temperaturstabile Teile der Anordnung können zum Beispiel eine kryogene Flüssigkeit oder ein Behälter, der durch solche gekühlt wird, sein. Eine andere Möglichkeit bieten die Enden des Pulsrohrkühlers, die im Betriebsfall eine definierte Temperatur aufweisen.

Für die folgende Diskussion wird als Geometrie des weichmagnetischen Materials ein Hohlzylinder mit Innendurchmesser $D$, Höhe $L$ und Wandstärke d betrachtet, obwohl andere Geometrien auch zu ähnlichen Resultaten führen würden. Der Einfachheit halber wird für das magnetische Regeneratormaterial r die Geometrie eines Vollzylinders mit Durchmesser $D_{Reg}$ und Höhe $L_{Reg}$ angenommen, wobei dieser Vollzylinder im Hohlzylinder des magnetischen Materials enthalten sein soll. Es soll hier betont werden, dass dieser Vollzylinder nur den Teil des magnetischen Regeneratormaterials r umfasst, in welchem die Temperaturschwankungen zu nennenswerten Schwankungen der Magnetisierung führen.

Für Felder senkrecht zur Zylinderachse bekommt man im Zentrum des Hohlzylinders den Abschirmfaktor

$$S_s = 1 + \frac{\mu_r d}{D}.$$

Für Felder parallel zur Zylinderachse ist der Abschirmfaktor

$$S_p = 1 + \frac{4N(S_s - 1)}{1 + \frac{D}{2L}}$$

mit dem so genannten Entmagnetisierungsfaktor $N$, der vom Verhältnis L/D abhängt. Es wird hier angenommen, dass $\mu_r \gg 1$ ist. Diese Formel gilt für beidseitig geschlossene Zylinder und ist somit nur für lange Hohlzylinder gültig. Ohne auf die Details einzugehen, sieht man, dass eine gute Abschirmwirkung mit einer hohen relativen Permeabilität $\mu_r$ erreicht werden kann. Die relative Permeabilität ist durch die Beziehung

$$B = \mu_0 \mu_r H$$

definiert und ist eine Funktion vom Feld $B$ (dieser Zusammenhang zwischen $B$ und $H$ definiert die so genannte BH-Kurve des Materials). Bei weichmagnetischen Materialien, die in der vorliegenden Patentanmeldung betrachtet werden, erreicht $\mu_r$ bei tiefen Feldern ein Maximum $\mu_{max}$ und nimmt dann bei großen Feldern ab mit einem asymptotischen Wert von 1. Sobald eine Zunahme ΔH zu einer Zunahme

$$\Delta B = \mu_0 \Delta H$$

führt, sagt man, dass das Material magnetisch gesättigt ist. Es kann größere Felder nicht mehr beeinflussen, weil alle Spins im Material bereits ausgerichtet sind. Das Eigenfeld des magnetischen Materials heißt in einer solchen Situation Sättigungsinduktion $B_s$ und kann durch die Formel

$$B_s = B - \mu_0 H$$

erhalten werden. Die Größe $B/\mu_0$-$H$ wird auch bei Feldern weit weg von der Sättigung mit dem Begriff "Magnetisierung" bezeichnet.

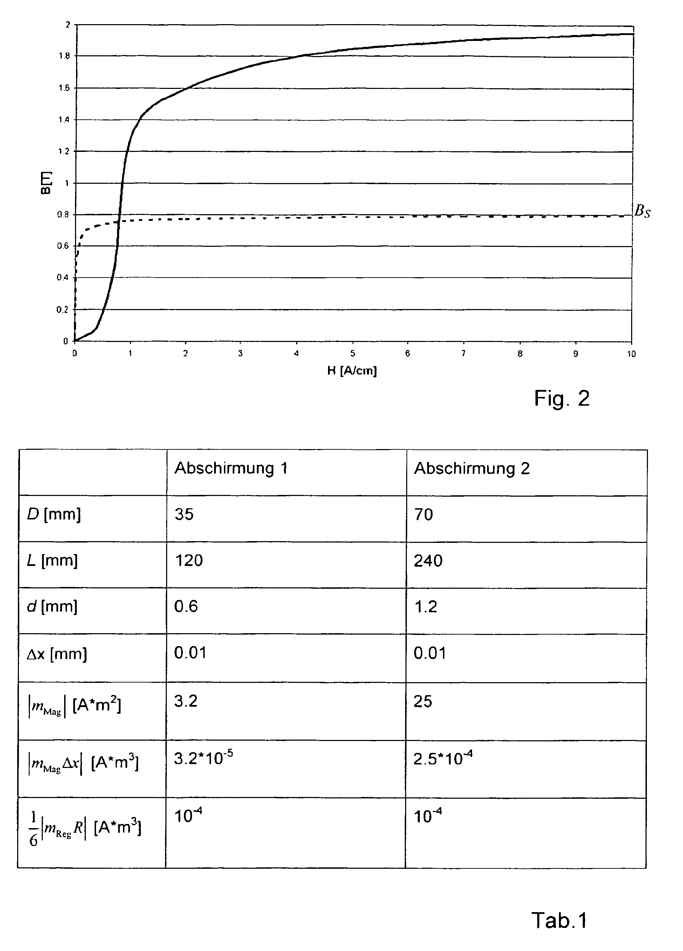

**Fig. 2** zeigt typische BH-Kurven für weichmagnetische Materialien mit hoher maximaler Permeabilität (gestrichelter Graph) beziehungsweise hoher maximaler Sättigungsinduktion (durchgezogener Graph). Der sehr steile Anstieg der BH-Kurve für Materialien mit einer großen maximalen Permeabilität $\mu_{max}$ bei bereits kleinen Feldstärken H zeigt, dass derartige Materialien zur effizienten Abschirmung von kleinen Magnetfeldern geeignet sind. Typischerweise ist es aber so, dass solche Materialien auch eine kleine Sättigungsinduktion $B_s$ besitzen (hier: 0,8T). Dies hat zur Folge, dass diese Materialien von größeren Magnetfeldern magnetisch gesättigt werden. Magnetische Sättigung bedeutet aber, dass ein Teil des Magnetfeldes ins Innere des Hohlzylinders eindringen kann. Um die magnetische Sättigung zu vermeiden, kann entweder die Wandstärke des Materials verstärkt, oder ein Material mit höherer Sättigungsinduktion (aber kleinerer maximaler Permeabilität $\mu_{max}$) verwendet werden. Wie in Fig. 2 gezeigt, weist die BH-Kurve von Materialien mit höherer Sättigungsinduktion jedoch einen weniger steilen Anstieg auf, wodurch lediglich eine weniger effektive Abschirmung erreicht werden kann. Bei starken Streufeldern kann daher im äußeren radialen Bereich des Hohlzylinders ein Material mit hoher Sättigungsinduktion, im inneren radialen Bereich des Hohlzylinders ein Material mit hoher maximaler Permeabilität verwendet werden. Der äußere Bereich wird vom Streufeld der Magnetanordnung nahe an die Sättigung getrieben, der innere Bereich befindet sich aber bereits in einem stark reduzierten Feld, welches er dann optimal abschirmen kann.

**Fig. 3b** zeigt eine Darstellung von Flusslinien **f** in der Nähe einer zylindrischen Abschirmung m aus weichmagnetischem Material. In diesem Beispiel würde das Feld ohne eine Abschirmung m aus weichmagnetischem Material parallel zur Achse des Zylinders zeigen. Im vergrößerten Ausschnitt in **Fig. 3a** kann man erkennen, dass die konzentrierten Feldlinien f am axialen Rand des Hohlzylinders die Abschirmung m aus magnetischem Material wieder verlassen. Es findet dort sogar eine Feldüberhöhung statt, das Feld wird also lokal noch größer als es ohne Abschirmung m war. Damit das Magnetfeld am Ort des magnetischen Regeneratormaterials r abgeschirmt wird, muss also die Höhe $L$ der Abschirmung m größer als die Höhe $L_{reg}$ des magnetischen Regeneratormaterials r sein. Wenn die hohlzylindrische magnetische Abschirmung m an jedem axialen Ende um D/3 über den Zylinder des magnetischen Regeneratormaterials r hinausragt, wird das Magnetfeld typischerweise im ganzen Vollzylinder des magnetischen Regeneratormaterials r um mindestens einen Faktor 2 abgeschirmt. Ragt er beidseitig um mehr als 2D über den Zylinder des magnetischen Regeneratormaterials r hinaus, kann die Abschirmwirkung nicht weiter verbessert werden.

Je größer die Höhe $L$ der hohlzylindrischen Abschirmung m ist, desto mehr Feldlinien des Magnetfeldes werden vom magnetischen Material der Abschirmung m angezogen, so dass die Magnetisierung im mittleren axialen Bereich des Zylinders immer größer wird. Ist die Höhe $L$ der hohlzylindrischen Abschirmung m zu groß, wird das magnetische Material in mittlerer Höhe L/2 in die magnetische Sättigung getrieben. In der Nähe der Sättigungsbereiche kann das magnetische Material der Abschirmung m keine Feldlinien mehr aufnehmen, so dass ein Teil des Magnetfeldes dort nicht mehr abgeschirmt wird. Dasselbe gilt für einen größer werdenden Durchmesser $D$. Falls D zu groß ist, tritt magnetische Sättigung ein und ein Teil des Magnetfeldes kann ins Innere der hohlzylindrischen Abschirmung m gelangen.

Um magnetische Sättigung zu vermeiden, kann entweder die Wandstärke *d* vergrößert oder die geometrischen Maße *L* oder *D* der Abschirmung m reduziert werden. Letztere Möglichkeit führt zu einer möglichst kleinen Menge an magnetischem Abschirmmaterial, was aufgrund der nachfolgenden Erläuterungen vorteilhaft ist.

Durch das Streufeld der Magnetanordnung M wird das Material der hohlzylindrischen Abschirmung m magnetisiert und bildet einen magnetischen Dipol. Obwohl ein Pulsrohrkühler P zu den vibrationsärmsten Kühlern überhaupt gehört, sind kleinere Vibrationen vorhanden. Auch bei guter mechanischer Entkopplung der hohlzylindrischen Abschirmung m und des magnetischen Regeneratormaterials r muss mit Vibrationen des Abschirmung m gerechnet werden. Die hohlzylindrische Abschirmung m kann als vibrierender magnetischer Dipol angesehen werden, welcher im Arbeitsvolumen der Magnetanordnung M eine periodische elektromagnetische Störung erzeugt, die unter Umständen größer ist als die ursprüngliche Störung des magnetischen Regeneratormaterials r. Um dieses Problem zu vermeiden, muss der Betrag der Feldstörung vom magnetischen Regeneratormaterial r und von der magnetischen Abschirmung m im Arbeitsvolumen V der Magnetanordnung M abgeschätzt werden. Das magnetische Regeneratormaterial r ist wegen der Temperaturschwankungen ein zeitlich veränderlicher Dipol. Bei einer mittleren Suszeptibilitätsschwankung mit Amplitude $\Delta\chi$ im Volumen des magnetischen Regeneratormaterials r während einem Zyklus ergibt sich eine Dipoländerung mit Amplitude

$$\left|m_{\mathrm{Reg}}\right| = \pi \frac{D_{\mathrm{Reg}}^{2}}{4} L_{\mathrm{Reg}} \left|\Delta\chi\right| \frac{B}{\mu_{0}} \; ,$$

wobei *B* das Streufeld der Magnetanordnung M am Ort des magnetischen Regeneratormaterials r bezeichnet. Der Einfachheit halber wird angenommen, dass die Richtung dieser Dipolschwankung die des Streufeldes der Magnetanordnung M am Ort des magnetischen Regeneratormaterials r ist. Definiert man ein zylindrisches Koordinatensystem mit Ursprung in der Mitte des magnetischen Regeneratormaterials r und z-Achse parallel zur Dipolrichtung, erzeugt dieser pulsierende Dipol im Arbeitsvolumen eine Störung mit Amplitude

$$B_{\mathrm{Reg}} = \frac{\mu_{0}\left|m_{\mathrm{Reg}}\right|}{4\pi} \frac{4z^{2}+\rho^{2}}{\left(\rho^{2}+z^{2}\right)^{2}} \, \frac{1}{\sqrt{4z^{2}+\rho^{2}}}$$

wobei z die mittlere axiale und ρ die mittlere radiale Koordinate des Arbeitsvolumens V der Magnetanordnung M in diesem lokalen Koordinatensystem bezeichnen. Die vibrierende magnetische Abschirmung m erzeugt hingegen im Arbeitsvolumen V der Magnetanordnung M ein Störfeld, das als Differenz von zwei Dipolfeldern berechnet werden kann. Da die Vibrationsamplitude $\Delta x$ klein ist, kann diese Differenz durch eine Ableitung approximiert werden. Ist die Vibration im eben definierten Koordinatensystem in z-Richtung, ergibt sich im Arbeitsvolumen V eine Störung mit Amplitude

$$B_{Mag} = \frac{\mu_{O}\left|m_{Mag}\right|}{4\pi} \frac{12\left|z^{3}\right|}{\left(\rho^{2}+z^{2}\right)^{3}} \frac{1}{\sqrt{4z^{2}-\rho^{2}}}\left|\Delta x\right| \le \frac{\mu_{O}\left|m_{Mag}\right|}{4\pi} \frac{3\left|z\right|\left(4z^{2}+\rho^{2}\right)}{\left(\rho^{2}+z^{2}\right)^{3}} \frac{1}{\sqrt{4z^{2}-\rho^{2}}}\left|\Delta x\right| \le$$

$$\le \frac{\mu_{O}\left|m_{Mag}\right|}{4\pi} \frac{3\left(4z^{2}+\rho^{2}\right)}{\left(\rho^{2}+z^{2}\right)^{5/2}} \frac{1}{\sqrt{4z^{2}-\rho^{2}}}\left|\Delta x\right|.$$

Ist die Vibration hingegen in ρ-Richtung, ergibt sich eine Störung mit Amplitude

$$B_{Mag} = \frac{\mu_{0}\left|m_{Mag}\right|}{4\mu} \frac{3\rho\left(5z^{2}+\rho^{2}\right)}{\left(\rho^{2}+z^{2}\right)^{3}} \frac{1}{\sqrt{4z^{2}-\rho^{2}}}\left|\Delta x\right| \approx \frac{\mu_{0}\left|m_{Mag}\right|}{4\mu} \frac{3\rho\left(4z^{2}+\rho^{2}\right)}{\left(\rho^{2}+z^{2}\right)^{3}} \frac{1}{\sqrt{4z^{2}-\rho^{2}}}\left|\Delta x\right| \le$$

$$\le \frac{\mu_{0}\left|m_{Mag}\right|}{4\mu} \frac{3\left(4z^{2}+\rho^{2}\right)}{\left(\rho^{2}+z^{2}\right)^{5/2}} \frac{1}{\sqrt{4z^{2}-\rho^{2}}}\left|\Delta x\right|$$

Mit der Abkürzung $R = (\rho^2 + z^2)^{1/2}$ erfüllt das Verhältnis der beiden Störamplituden folgende Ungleichung:

$$\frac{B_{\text{Mag}}}{B_{\text{Reg}}} \leq \frac{3|\Delta x|}{R} \left| \frac{m_{\text{Mag}}}{m_{\text{Reg}}} \right|.$$

Wenn also die Ungleichung

$$\left| m_{\text{Mag}} \Delta x \right| < \frac{1}{6} \left| m_{\text{Reg}} R \right|$$

erfüllt ist, ist die Störung, die aufgrund von der vibrierenden Abschirmung m im Arbeitsvolumen V erzeugt wird, mindestens einen Faktor zwei kleiner als diejenige, die das magnetische Regeneratormaterial r ohne magnetische Abschirmung m erzeugen würde. Für den Fall, dass die magnetische Abschirmung m das Streufeld der Magnetanordnung M am Ort des Regeneratormaterials nicht total abschirmt, muss auf der linken Seite der Ungleichung noch der Beitrag der verbleibenden Störung des magnetischen Regeneratormaterials r hinzugefügt werden. Man bekommt somit allgemeiner die Bedingung

$$\frac{1}{3} \left| \tilde{m}_{\text{Reg}} R \right| + \left| m_{\text{Mag}} \Delta x \right| < \frac{1}{6} \left| m_{\text{Reg}} R \right|,$$

wobei $\tilde{m}_{\text{Reg}}$ das verbleibende Dipolmoment des magnetischen Regeneratormaterials r in Anwesenheit der magnetischen Abschirmung m bezeichnet.

Um diese Ungleichung zu illustrieren, wird nun ein numerisches Beispiel angegeben, in welchem das verbleibende Dipolmoment $\tilde{m}_{\text{Reg}}$ des magnetischen Regeneratormaterials r verschwindend klein ist. Es wird ein Streufeld von 3 [mTesla] am Ort des magnetischen Regeneratormaterials r angenommen. Dieses Feld soll parallel zur Achse des Regeneratorzylinders sein. Dieser Zylinder soll die Maße $D_{\text{Reg}} = 30$ [mm] und $L_{\text{Reg}} = 60$ [mm] aufweisen. Die Fluktuation der Suszeptibilität soll $|\Delta\chi| = 0.01$ betragen. Aus diesen Daten ergibt sich mit der Formel

$$\left| m_{\text{Reg}} \right| = \pi \frac{D_{\text{Reg}}^{2}}{4} L_{\text{Reg}} \left| \Delta\chi \right| \frac{B}{\mu_0}$$

eine Dipolmomentschwankung von $|m_{\text{Reg}}| = 10^{-3}$ [A*m$^2$].

Der Einfluss der Geometrie der erfindungsgemäßen Abschirmung m aus magnetischem Material wird aus folgendem Beispiel deutlich:

Tabelle 1 zeigt zwei Abschirmvarianten, die sich durch einen Faktor zwei in allen geometrischen Größen unterscheiden, was zur gleichen Abschirmwirkung auf der Achse der hohlzylindrischen Abschirmung m führt. Unabhängig von den genauen Materialeigenschaften wird sich die Magnetisierung der hohlzylindrischen Abschirmung m bei hinreichender Permeabilität des Materials bei beiden Abschirmvarianten so einstellen, dass das Streufeld am Ort des magnetischen Regeneratormaterials r gut kompensiert wird, so dass $\tilde{m}_{\text{Reg}}$ im Folgenden vernachlässigt werden kann. Mit numerischen Methoden (z. B. mit der Methode der finiten Elemente) kann die Magnetisierung im Material berechnet werden. An beiden axialen Enden des Zylinders des Abschirmmaterials ergibt sich eine Magnetisierung von etwa $2.4 \times 10^5$ [A/m], in der Mitte von etwa $5.6 \times 10^5$ [A/m]. In beiden Fällen kann von einer mittleren Magnetisierung von etwa $4 \times 10^5$ [A/m] im magnetischen Material der Abschirmung m ausgegangen werden. Multipliziert man die Magnetisierung mit dem Volumen des Materials, bekommt man den Wert für das Dipolmoment $|m_{\text{Mag}}|$, der in Tabelle 1 eingetragen ist. Nimmt man an, dass sich das magnetische - Regeneratormaterial r in einem mittleren Abstand $R$ von 600 [mm] vom Arbeitsvolumen befindet, bekommt man für das Produkt $\frac{1}{6}\left|m_{\text{Reg}}R\right|$ |$m_{\text{Reg}}R$| einen Wert von $10^{-4}$ [A*m$^3$]. Die Ungleichung

$$\left|m_{\text{Mag}}\Delta x\right| < \frac{1}{6}\left|m_{\text{Reg}}R\right|$$

ist nur in der ersten Abschirmvariante erfüllt. In der zweiten Abschirmvariante kann davon ausgegangen werden, dass die elektromagnetischen Störungen, welche aufgrund der Vibrationen des magnetischen Abschirmmaterials im Arbeitsvolumen V entstehen, etwa gleich groß sind wie die ursprünglichen elektromagnetischen Störungen des magnetischen Regeneratormaterials r, die man abschirmen wollte. Die zweite Abschirmvariante erfüllt deshalb nicht das Ziel einer Reduzierung der elektromagnetischen Störungen im Arbeitsvolumen V.

Die im magnetischem Regeneratormaterial r und im magnetischen Material der Abschirmung m noch entstehenden Störungen können durch eine gut leitende Abschirmung (nicht gezeigt), die beide umschließt, noch weiter abgeschirmt werden. Die gut leitende Abschirmung kann supraleitend oder normal leitend sein. Der Vorteil einer normal leitenden Abschirmung liegt darin, dass nur Abschirmströme fließen und so keine permanenten Ströme vorhanden sind, die die Homogenität im Arbeitsvolumen V oder das Streufeld der Magnetanordnung M negativ beeinflussen können. Auch kann jede Quenchgefahr bei einer normal leitenden Abschirmung ausgeschlossen werden.

Mit der erfindungsgemäßen Abschirmung ist es daher erstmals möglich, ein Magnetsystem zu realisieren, das die Vorteile eines Pulsrohrkühlers ausnutzen kann und gleichzeitig die durch den Pulsrohrkühler hervorgerufenen elektromagnetischen Störungen kompensiert, so dass ein möglichst stabiles, zeitlich konstantes Magnetfeld im Arbeitsvolumen realisiert werden kann.

**Patentansprüche**

1. Magnetsystem mit einer Magnetanordnung, einem Arbeitsvolumen und einem Pulsrohrkühler mit magnetischem Regeneratormaterial,
   **dadurch gekennzeichnet,**
   **dass** zur Reduzierung von Dipolschwankungen des magnetischen Regeneratormaterials eine Abschirmung aus magnetischem Material vorgesehen ist, welche das Streufeld der Magnetanordnung am Ort des magnetischen Regeneratormaterials reduziert und sich **dadurch** auszeichnet, dass

$$\frac{1}{3}\left|\tilde{m}_{\text{Reg}}R\right| + \left|m_{\text{Mag}}\Delta x\right| < \frac{1}{6}\left|m_{\text{Reg}}R\right|$$

   mit

   $m_{\text{Mag}}$ : Dipolmoment des magnetischen Materials der Abschirmung (m)
   $\Delta$x : Vibrationsamplitude des magnetischen Materials der Abschirmung
   $m_{\text{Reg}}$ : Amplitude der Dipolschwankungen des magnetischen Regeneratormaterials in einem Zyklus ohne magnetische Abschirmung
   $\tilde{m}_{\text{Reg}}$ : Amplitude der Dipolschwankungen des magnetischen Regeneratormaterials in einem Zyklus mit magnetischer Abschirmung
   $R$ : mittlerer Abstand des magnetischen Regeneratormaterials (r) zum Arbeitsvolumen

2. Magnetsystem nach Anspruch 1, **dadurch gekennzeichnet, dass** das Magnetsystem mit einer supraleitenden Magnetanordnung in einem Kryostaten ausgestattet ist und der Pulsrohrkühler zur Kühlung der Magnetanordnung oder Teile des Kryostaten vorgesehen ist.

3. Magnetsystem nach Anspruch 1 oder 2, **dadurch gekennzeichnet, dass** der Pulsrohrkühler zur Kühlung einer Messvorrichtung vorgesehen ist.

4. Magnetsystem nach Anspruch 1 bis 3, **dadurch gekennzeichnet, dass** das magnetische Material der Abschirmung eine maximale Permeabilität $\mu_{\text{max}}$ von mindestens 10000 aufweist.

**5.** Magnetsystem nach einem der vorhergehenden Ansprüche, **dadurch gekennzeichnet, dass** die Sättigungsinduktion des magnetischen Materials mindestens 1 Tesla, vorzugsweise 2 Tesla, beträgt.

**6.** Magnetsystem nach einem der vorhergehenden Ansprüche, **dadurch gekennzeichnet, dass** die magnetische Abschirmung mindestens einen Hohlzylinder umfasst, der das abzuschirmende magnetische Regeneratormaterial umschließt.

**7.** Magnetsystem nach Anspruch 6, **dadurch gekennzeichnet, dass** der innere Teil des Hohlzylinders aus Material mit hoher Permeabilität $\mu_{max}$>10000 besteht, während der äußere Teil aus Material mit hoher Sättigungsinduktion >1 Tesla besteht.

**8.** Magnetsystem nach Anspruch 6 oder 7, **dadurch gekennzeichnet, dass** der Außendurchmesser des Hohlzylinders kleiner ist als das 1,5fache des Außendurchmessers des abzuschirmenden magnetischen Regeneratormaterials ist.

**9.** Magnetsystem nach einem der Ansprüche 6 bis 8, **dadurch gekennzeichnet, dass** mindestens ein axiales Ende des Hohlzylinders das abzuschirmende magnetische Regeneratormaterial um mindestens ein Drittel des Innendurchmessers des Hohlzylinders überragt.

**10.** Magnetsystem nach einem der Ansprüche 6 bis 9, **dadurch gekennzeichnet, dass** mindestens ein axiales Ende des Hohlzylinders das abzuschirmende magnetische Regeneratormaterial um höchstens das Zweifache des Innendurchmessers des Hohlzylinders überragt.

**11.** Magnetsystem nach einem der Ansprüche 6 bis 10, **dadurch gekennzeichnet, dass** das abzuschirmende magnetische Regeneratormaterial lediglich Bereiche des Regeneratormaterials umfasst, an denen Magnetisierungsschwankungen stattfinden, die mehr als 10% der im Regeneratorbetrieb auftretenden maximalen Magnetisierungsschwankung innerhalb des gesamten Regeneratormaterials betragen.

**12.** Magnetsystem nach einem der vorhergehenden Ansprüche, **dadurch gekennzeichnet, dass** sich im Betrieb zumindest ein Teil des magnetischen Materials nicht in der magnetischen Sättigung befindet.

**13.** Magnetsystem nach einem der vorhergehenden Ansprüche, **dadurch gekennzeichnet, dass** die Abschirmung aus magnetischen Material temperaturstabilisert, insbesondere wärmeleitend mit einem Strahlungsschild, einer Kältestufe des Pulsrohrkühlers oder einem Behälter mit kryogener Flüssigkeit verbunden ist.

**14.** Magnetsystem nach einem der vorhergehenden Ansprüche, **dadurch gekennzeichnet, dass** die Abschirmung aus magnetischen Material vom magnetischem Regeneratormaterial thermisch isoliert ist.

**15.** Magnetsystem nach einem der vorhergehenden Ansprüche, **dadurch gekennzeichnet, dass** zusätzlich zur magnetischen Abschirmung auch eine Abschirmung aus elektrisch gut leitendem Material um das magnetische Regeneratormaterial vorsehen ist.

**16.** Magnetsystem nach Anspruch 15, **dadurch gekennzeichnet, dass** die Abschirmung aus elektrisch gut leitendem Material Teile mit einer Zylindersymmetrie aufweist, und dass die Magnetfeldänderungen des magnetischen Regeneratormaterials und/oder der magnetischen Abschirmung am Ort der elektrisch gut leitenden Abschirmung überwiegend in Richtung der entsprechenden Zylinderachse zeigen.

**17.** Magnetsystem nach Anspruch 15 oder 16, **dadurch gekennzeichnet, dass** das elektrisch gut leitende Material ein Tieftemperatursupraleiter ist.

**18.** Magnetsystem nach Anspruch 15 oder 16, **dadurch gekennzeichnet, dass** das elektrisch gut leitende Material ein Hochtemperatursupraleiter ist.

**19.** Magnetsystem nach Anspruch 15 bis 18, **dadurch gekennzeichnet, dass** das elektrisch gut leitende Material aus Massivmaterial besteht.

**20.** Magnetsystem nach Anspruch 15 bis 18, **dadurch gekennzeichnet, dass** das elektrisch gut leitende Material eine Solenoidspule bildet.

**21.** Magnetsystem nach einem der vorhergehenden Ansprüche, **dadurch gekennzeichnet, dass** die Magnetanordnung mit Spulen zur Streufeldunterdrückung ausgestattet ist.

**22.** Magnetsystem nach Anspruch 21, **dadurch gekennzeichnet, dass** das Magnetfeld am Ort des magnetischen Regeneratormaterials 10 mT nicht überschreitet.

**23.** Magnetsystem nach einem der vorhergehenden Ansprüche, **dadurch gekennzeichnet, dass** die Magnetanordnung Spulen aufweist, welche die elektromagnetischen Störungen der vibrierenden magnetischen Abschirmung unterdrückt.

**24.** Magnetsystem nach Anspruch 2 bis 23, **dadurch gekennzeichnet, dass** der Kryostat einen Strahlungsschild enthält, welchen der Pulsrohrkühler auf seine Betriebstemperatur bringt.

**25.** Magnetsystem nach Anspruch 2 bis 24, **dadurch gekennzeichnet, dass** der Kryostat einen Behälter mit flüssigem Stickstoff enthält, welchen der Pulsrohrkühler nach dem Verdampfen mindestens teilweise wieder verflüssigt.

**26.** Magnetsystem nach Anspruch 2 bis 25, **dadurch gekennzeichnet, dass** die Magnetanordnung mit flüssigem Helium gekühlt wird, welches nach dem Verdampfen vom Pulsrohrkühler mindestens teilweise wieder verflüssigt wird.

**27.** Magnetsystem nach einem der Ansprüche 2 bis 24, **dadurch gekennzeichnet, dass** die supraleitende Magnetanordnung ohne kryogene Flüssigkeit vom Pulsrohrkühler auf ihre Betriebstemperatur gebracht und/oder gehalten werden kann.

**28.** Magnetsystem nach einem der vorhergehenden Ansprüche, **dadurch gekennzeichnet, dass** die supraleitende Magnetanordnung Teil einer Apparatur zur Kernspinresonanz, insbesondere Magnetic Resonance Imaging (MRI) oder Magnetresonanzspektroskopie (NMR) ist.

**29.** Verfahren zum Betrieb eines Magnetsystems nach einem der Ansprüche 17 bis 20, **dadurch gekennzeichnet, dass** das supraleitende Material während des Ladens der Magnetanordnung induktiv geladen wird.

**Claims**

**1.** Magnet system comprising a magnet arrangement, a working volume and a pulse tube cooler with magnetic regenerator material, **characterized in that**,

for reducing dipole fluctuations of the magnetic regenerator material, a shielding of magnetic material is provided, which reduces the stray field of the magnet arrangement at the location of the magnetic regenerator material and is distinguished **in that**

$$\frac{1}{3}\left|\tilde{m}_{\mathrm{Reg}}R\right| + \left|m_{\mathrm{Mag}}\Delta x\right| < \frac{1}{6}\left|m_{\mathrm{Reg}}R\right|,$$

with

$m_{\mathrm{Mag}}$: dipole moment of the magnetic material of the shielding (m)
$\Delta$x: vibration amplitude of the magnetic material of the shielding
$m_{\mathrm{Reg}}$: amplitude of the dipole fluctuations of the magnetic regenerator material in one cycle without magnetic shielding
$\tilde{m}_{\mathrm{Reg}}$ : amplitude of the dipole fluctuations of the magnetic regenerator material in one cycle with magnetic shielding
R: average separation of the magnetic regenerator material (r) from the working volume.

**2.** Magnet system according to claim 1, **characterized in that** the magnet system comprises a superconducting magnet arrangement in a cryostat, and the pulse tube cooler is provided for cooling the magnet arrangement or parts of the cryostat.

**3.** Magnet system according to claim 1 or 2, **characterized in that** the pulse tube cooler is provided for cooling a measuring device.

**4.** Magnet system according to claims 1 to 3, **characterized in that** the magnetic material of the shielding has a maximum permeability $\mu_{max}$ of at least 10,000.

**5.** Magnet system according to any one of the preceding claims, **characterized in that** the saturation induction of the magnetic material is at least 1 Tesla, advantageously 2 Tesla.

**6.** Magnet system according to any one of the preceding claims, **characterized in that** the magnetic shielding comprises at least one hollow cylinder which surrounds the magnetic regenerator material to be shielded.

**7.** Magnet system according to claim 6, **characterized in that** the inner part of the hollow cylinder consists of material having a high permeability $\mu_{max} > 10,000$ while the outer part thereof consists of material having a high saturation induction >1Tesla.

**8.** Magnet system according to claim 6 or 7, **characterized in that** the outer diameter of the hollow cylinder is smaller than 1.5 times the outer diameter of the magnetic regenerator material to be shielded.

**9.** Magnet system according to any one of the claims 6 to 8, **characterized in that** at least one axial end of the hollow cylinder extends beyond the magnetic regenerator material to be shielded by at least one third of the inner diameter of the hollow cylinder.

**10.** Magnet system according to any one of the claims 6 to 9, **characterized in that** at least one axial end of the hollow cylinder extends beyond the magnetic regenerator material to be shielded by at most twice the inner diameter of the hollow cylinder.

**11.** Magnet system according to any one of the claims 6 to 10, **characterized in that** the magnetic regenerator material to be shielded only includes regions of the regenerator material where magnetization fluctuations occur, which exceed 10% of the maximum magnetization fluctuations within the entire regenerator material, which occur during regenerator operation.

**12.** Magnet system according to any one of the preceding claims, **characterized in that** at least part of the magnetic material is not magnetically saturated during operation.

**13.** Magnet system according to any one of the preceding claims, **characterized in that** the shielding of magnetic material is connected in a temperature-stabilized fashion, in particular, in a thermally conducting fashion to a radiation shield, to a cold stage of the pulse tube cooler, or to a container containing cryogenic liquid.

**14.** Magnet system according to any one of the preceding claims, **characterized in that** the shielding of magnetic material is thermally insulated from the magnetic regenerator material.

**15.** Magnet system according to any one of the preceding claims, **characterized in that**, in addition to the magnetic shielding, a shielding of material having good electrical conducting properties is also provided around the magnetic regenerator material.

**16.** Magnet system according to claim 15, **characterized in that** the shielding of material having good electrical conducting properties has cylindrically symmetrical parts, and the magnetic field changes of the magnetic regenerator material and/or of the magnetic shielding at the location of the shielding having good electrical conducting properties are substantially oriented towards the corresponding cylinder axis.

**17.** Magnet system according to claim 15 or 16, **characterized in that** the material having good electrical conducting properties is a low-temperature superconductor.

**18.** Magnet system according to claim 15 or 16, **characterized in that** the material having good electrical conducting properties is a high-temperature superconductor.

**19.** Magnet system according to claims 15 to 18, **characterized in that** the material having good electrical conducting properties consists of bulk material.

**20.** Magnet system according to claims 15 to 18, **characterized in that** the material having good electrical conducting properties forms a solenoid coil.

**21.** Magnet system according to any one of the preceding claims, **characterized in that** the magnet arrangement comprises coils for stray field suppression.

**22.** Magnet system according to claim 21, **characterized in that** the magnetic field at the location of the magnetic regenerator material does not exceed 10mT.

**23.** Magnet system according to any one of the preceding claims, **characterized in that** the magnet arrangement comprises coils which suppress electromagnetic disturbances of the vibrating magnetic shielding.

**24.** Magnet system according to claims 2 to 23, **characterized in that** the cryostat contains a radiation shield, which is brought to its operating temperature by the pulse tube cooler.

**25.** Magnet system according to claims 2 to 24, **characterized in that** the cryostat comprises a container containing liquid nitrogen which is at least partially re-liquefied by the pulse tube cooler after evaporation thereof.

**26.** Magnet system according to claims 2 to 25, **characterized in that** the magnet arrangement is cooled with liquid helium which is at least partially re-liquefied by the pulse tube cooler after evaporation thereof.

**27.** Magnet system according to any one of the claims 2 to 24, **characterized in that** the superconducting magnet arrangement can be brought to and/or kept at its operating temperature by the pulse tube cooler, without the assistance of a cryogenic liquid.

**28.** Magnet system according to any one of the preceding claims, **characterized in that** the superconducting magnet arrangement is part of an apparatus for nuclear magnetic resonance, in particular, magnetic resonance imaging (MRI), or magnetic resonance spectroscopy (NMR).

**29.** Method for operating a magnet system according to any one of the claims 17 to 20, **characterized in that** the superconducting material is inductively charged during charging of the magnet arrangement.

**Revendications**

**1.** Système magnétique comprenant un dispositif magnétique, un volume de travail et un réfrigérateur à tube pulsé avec matériau régénérateur magnétique,
**caractérisé en ce**
**que** pour réduire les fluctuations dipolaires du matériau régénérateur magnétique, il est prévu un blindage en matériau magnétique qui réduit le champ de dispersion du dispositif magnétique à l'emplacement du matériau régénérateur magnétique et se distingue par le fait que

$$\frac{1}{3}\left|\tilde{m}_{\mathrm{Reg}}R\right|+\left|m_{\mathrm{Mag}}\Delta x\right|<\frac{1}{6}\left|m_{\mathrm{Reg}}R\right|$$

avec

$m_{\mathrm{Mag}}$ : moment dipolaire du matériau magnétique du blindage (m)
$\Delta$x: amplitude de vibration du matériau magnétique du blindage
$m_{\mathrm{Reg}}$ : amplitude des fluctuations dipolaires du matériau régénérateur magnétique dans un cycle sans blindage magnétique
$\tilde{m}_{\mathrm{Reg}}$ : amplitude des fluctuations dipolaires du matériau régénérateur magnétique dans un cycle avec blindage magnétique
R : distance moyenne du matériau régénérateur magnétique (r) au volume de travail

**EP 1 596 214 B1**

**2.** Système magnétique selon la revendication 1, **caractérisé en ce que** le système magnétique est équipé d'un dispositif magnétique supraconducteur dans un cryostat et le réfrigérateur à tube pulsé est prévu pour refroidir le dispositif magnétique ou des parties du cryostat.

**3.** Système magnétique selon la revendication 1 ou 2, **caractérisé en ce que** le réfrigérateur à tube pulsé est prévu pour refroidir un dispositif de mesure.

**4.** Système magnétique selon les revendications 1 à 3, **caractérisé en ce que** le matériau magnétique du blindage présente une perméabilité maximale $\mu_{max}$ d'au moins 10 000.

**5.** Système magnétique selon une des revendications précédentes, **caractérisé en ce que** l'induction de saturation du matériau magnétique est d'au moins 1 tesla, de préférence de 2 teslas.

**6.** Système magnétique selon une des revendications précédentes, **caractérisé en ce que** le blindage magnétique comprend au moins un cylindre creux qui renferme le matériau régénérateur magnétique à blinder.

**7.** Système magnétique selon la revendication 6, **caractérisé en ce que** la partie intérieure du cylindre creux est composée d'un matériau à haute perméabilité $\mu_{max} > 10\ 000$, tandis que la partie extérieure est composée d'un matériau à haute induction de saturation >1 tesla.

**8.** Système magnétique selon la revendication 6 ou 7, **caractérisé en ce que** le diamètre extérieur du cylindre creux est inférieur à 1,5 fois le diamètre extérieur du matériau régénérateur magnétique à blinder.

**9.** Système magnétique selon une des revendications 6 à 8, **caractérisé en ce qu'**au moins une extrémité axiale du cylindre creux dépasse le matériau régénérateur magnétique à blinder d'au moins un tiers du diamètre intérieur du cylindre creux.

**10.** Système magnétique selon une des revendications 6 à 9, **caractérisé en ce qu'**au moins une extrémité axiale du cylindre creux dépasse le matériau régénérateur magnétique à blinder d'au plus du double du diamètre intérieur du cylindre creux.

**11.** Système magnétique selon une des revendications 6 à 10, **caractérisé en ce que** le matériau régénérateur magnétique à blinder comprend seulement des zones du matériau régénérateur dans lesquelles apparaissent des fluctuations de magnétisation qui s'élèvent à plus de 10 % de la fluctuation de magnétisation maximale qui apparaît en mode régénérateur au sein de l'ensemble du matériau régénérateur.

**12.** Système magnétique selon une des revendications précédentes, **caractérisé en ce qu'**en fonctionnement, au moins une partie du matériau magnétique ne se trouve pas à la saturation magnétique.

**13.** Système magnétique selon une des revendications précédentes, **caractérisé en ce que** le blindage en matériau magnétique est relié de manière stabilisée en température, en particulier thermoconductrice à un écran anti-rayonnement, un étage de réfrigération du réfrigérateur à tube pulsé ou un réservoir contenant un liquide cryogénique.

**14.** Système magnétique selon une des revendications précédentes, **caractérisé en ce que** le blindage en matériau magnétique est isolé thermiquement du matériau régénérateur magnétique.

**15.** Système magnétique selon une des revendications précédentes, **caractérisé en ce qu'**en plus du blindage magnétique, il est prévu un blindage en matériau bon conducteur de l'électricité autour du matériau régénérateur magnétique.

**16.** Système magnétique selon la revendication 15, **caractérisé en ce que** le blindage en matériau bon conducteur de l'électricité présente des parties ayant une symétrie cylindrique, et que les variations de champ magnétique du matériau régénérateur magnétique et/ou du blindage magnétique à l'emplacement du blindage bon conducteur de l'électricité sont orientées principalement dans la direction de l'axe de cylindre correspondant.

**17.** Système magnétique selon la revendication 15 ou 16, **caractérisé en ce que** le matériau bon conducteur de l'électricité est un supraconducteur à basse température.

**18.** Système magnétique selon la revendication 15 ou 16, **caractérisé en ce que** le matériau bon conducteur de l'électricité est un supraconducteur à haute température.

**19.** Système magnétique selon les revendications 15 à 18, **caractérisé en ce que** le matériau bon conducteur de l'électricité est constitué d'un matériau massif.

**20.** Système magnétique selon les revendications 15 à 18, **caractérisé en ce que** le matériau bon conducteur de l'électricité forme un solénoïde.

**21.** Système magnétique selon une des revendications précédentes, **caractérisé en ce que** le dispositif magnétique est équipé de bobines de suppression du champ de dispersion.

**22.** Système magnétique selon la revendication 21, **caractérisé en ce que** le champ magnétique à l'emplacement du matériau régénérateur magnétique ne dépasse pas 10 mT.

**23.** Système magnétique selon une des revendications précédentes, **caractérisé en ce que** le dispositif magnétique présente des bobines qui suppriment les perturbations électromagnétiques du blindage magnétique vibrant.

**24.** Système magnétique selon les revendications 2 à 23, **caractérisé en ce que** le cryostat contient un écran anti-rayonnement qui amène le réfrigérateur à tube pulsé à sa température de fonctionnement.

**25.** Système magnétique selon les revendications 2 à 24, **caractérisé en ce que** le cryostat contient un réservoir avec de l'azote liquide que le réfrigérateur à tube pulsé recondense au moins partiellement après l'évaporation.

**26.** Système magnétique selon les revendications 2 à 25, **caractérisé en ce que** le dispositif magnétique est refroidi avec de l'hélium liquide qui est recondensé au moins partiellement par le réfrigérateur à tube pulsé après l'évaporation.

**27.** Système magnétique selon une des revendications 2 à 24, **caractérisé en ce que** le dispositif magnétique supraconducteur peut être amené et/ou maintenu à sa température de fonctionnement sans liquide cryogénique par le réfrigérateur à tube pulsé.

**28.** Système magnétique selon une des revendications précédentes, **caractérisé en ce que** le dispositif magnétique supraconducteur fait partie d'un appareil à résonance magnétique, en particulier d'imagerie par résonance magnétique (IRM) ou de spectroscopie par résonance magnétique (RMN).

**29.** Procédé de fonctionnement d'un système magnétique selon une des revendications 17 à 20, **caractérisé en ce que** le matériau supraconducteur est chargé inductivement pendant la charge du dispositif magnétique.

Fig. 1

Fig. 2

|  | Abschirmung 1 | Abschirmung 2 |
|---|---|---|
| $D$ [mm] | 35 | 70 |
| $L$ [mm] | 120 | 240 |
| $d$ [mm] | 0.6 | 1.2 |
| $\Delta x$ [mm] | 0.01 | 0.01 |
| $\left\|m_{Mag}\right\|$ [A*m$^2$] | 3.2 | 25 |
| $\left\|m_{Mag}\Delta x\right\|$ [A*m$^3$] | $3.2*10^{-5}$ | $2.5*10^{-4}$ |
| $\frac{1}{6}\left\|m_{Reg}R\right\|$ [A*m$^3$] | $10^{-4}$ | $10^{-4}$ |

Tab.1

f

m

Fig. 3a

f

m

Fig. 3b

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0905434 A
- US 6029458 A
- US 5701744 A
- EP 0905524 A